# EUROPEAN PATENT APPLICATION

(11) **EP 2 236 649 A1**
(43) Date of publication of application: **06.10.2010**
(21) Application number: 10003407.3
(22) Date of filing: 30.03.2010
(51) Int. Cl.: C23C 26/00

(54) **Deposition process of a nanocomposite film and apparatus therefor**

(30) Priority: 02.04.2009 IT MI20090531
(71) Applicant: Protec Surface Technologies S.r.L., 25081 Bedizzole (BS) (IT)
(72) Inventor: Pitacco, Fabrizio, 25081 Bedizzole (Brescia) (IT); Tosti, Michele, 25081 Bedizzole (Brescia) (IT)
(74) Representative: Lunati & Mazzoni S.r.L.

(57) **Abstract**

It is provided a deposition process (1) of film (10) on surfaces to be coated (20) in particular consisting in a PVD process, comprising: a deposition step (2) of an aggregating layer (11) involving a high-vacuum deposition process consisting in a PVD process, and an inclusion step (3) of nanoparticles (12) simultaneous with said deposition step (2), the aggregating layer (11) being suitable to retain and at least partly encapsulate the nanoparticles (12) on the surface to be coated (20).

## Description

The present invention relates to a deposition process of thin films on surfaces to be coated, through PVD techniques, of the type pointed out in the preamble of the first claim.

Presently known are different deposition processes of thin films on surfaces to be coated.

In particular, known are deposition processes of thin films through high-vacuum processes, specifically belonging to the PVD and/or CVD families.

Some examples of these processes are described in patent documents US-A-200823087 and WO-A-2005056872 A1.

In these processes the materials constituting the thin films are made available using different technologies and are then laid down on the surfaces to be coated in a high-vacuum environment.

In particular, known are processes referred to as PVD (Physical Vapour Deposition) processes.

In PVD processes the materials that have to constitute the film are made available in the form of gases, vapours and/or particles for example, inside the volume of a vacuum chamber in which the surfaces to be coated are places.

Said surfaces are generally fastened to frames set in motion, for instance in rotation, on suitable supports, at the inside of the vacuum chamber itself.

Therefore the particles or the like present inside the chamber come into contact with the surfaces to be coated onto which they adhere.

Generally, by means of PVD techniques it is possible for example to lay pure or alloy metals, nitrides, carbonitrides or oxides and others.

Also known are processes referred to as CVD (Chemical Vapour Deposition) processes, that are similar to PVD processes.

However in CVD processes precursors of the materials that will have to constitute the film are used, i.e. materials that following foreseen chemical reactions will compose the film.

These materials are then diffused within a vacuum chamber in which the surfaces to be coated, preferably set in motion, are placed.

The precursor then comes into contact with the surfaces to be coated on which it decomposes giving rise to a desired film.

Generally by means of CVD techniques it is possible for instance to lay pure or alloy metals, nitrides, carbonitrides, oxides and also carbon compounds and polymers or others.

The known art mentioned above has some important drawbacks.

In the industrial field it is not possible to give the thin films laid down, and consequently the articles of manufacture coated with said films, some particular aesthetic and/or chromatic and/or protective and/or tribologic properties through use of the above mentioned techniques alone; these particular properties, should it be possible to obtain some of them, would necessarily involve use of one or more industrial processes, also of different types relative to the mentioned ones, often to the detriment of the quality and/or with high application costs and/or poor respect for the environment.

Under this situation, the technical task underlying the present invention is to provide a single deposition process of thin films on surfaces to be coated capable of substantially obviating the mentioned drawbacks.

The invention therefore aims at giving the thin films laid down and consequently the articles of manufacture coated therewith, particular aesthetic and/or chromatic and/or protective and/or tribologic properties that cannot be obtained or at all events are hardly obtainable with the traditional surface coating techniques in the industrial field.

Another aim of the invention relates to the possibility of obtaining thin films with the features listed in the preceding paragraph, taking into examination production methods that, as regards morphology and nature of the articles of manufacture to be coated, consumer materials used, configuration of the machinery, production times, allow a reduction in costs and a reduced environmental impact while at the same time ensuring a good repeatability of the process combined with a high quality of the finished product.

The technical task mentioned and the aims specified are achieved by a deposition process of thin films on surfaces to be coated as claimed in the appended Claim 1.

### Preferred embodiments are highlighted in the sub-claims.

The features and advantages of the invention are hereinafter clarified by the detailed description of a preferred embodiment of the invention, with reference to the accompanying drawings, in which:

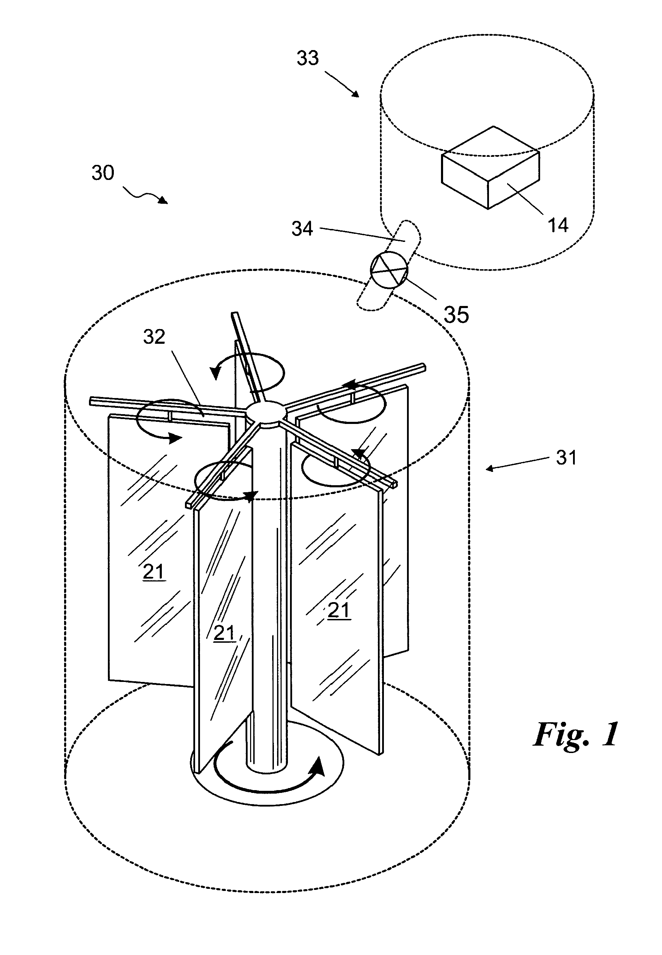

**Fig. 1** shows a diagram of an apparatus adapted to put into practice the process according to the invention;
**Fig. 2a** diagrammatically shows a first surface made using the process of the invention;
**Fig. 2b** diagrammatically shows a second surface made using the process according to the invention; and

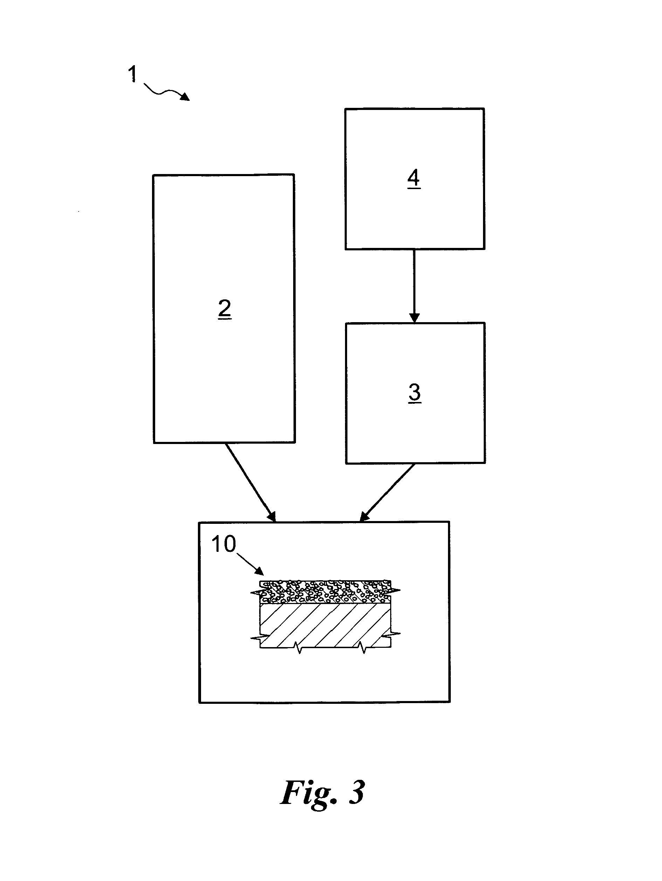

**Fig. 3** is a diagram of the process steps in accordance with the invention.

With reference to the mentioned figures, the process according to the invention is generally identified with reference numeral **1.**

In summary, it consists of an aggregate co-deposition process, i.e. simultaneous deposition of thin films and nanoparticles.

It comprises two steps carried out simultaneously: a deposition step **2** of an aggregating layer **11** and an inclusion step **3** of nanoparticles **12,** to form a film **10** on the whole, in particular a thin film, on surfaces to be coated 20 of elements **21.**

The film 10 is hereinafter immediately described in its main components, i.e. the aggregating layer 11 and nanoparticles 12.

In particular, the aggregating layer 11 will act as the "bonding or aggregating agent" or "glue" for the nanoparticles 12 on the surface to be coated 20.

The aggregating layer 11 is made of materials that can be laid down through the PVD process, for instance: metals, alloys, nitrides, carbonitrides, oxides, carbon compounds, polymers or still others.

### The nanoparticles 12 on the contrary can consist of any material.

In particular, the nanoparticles 12 have at least two sizes smaller than 100 nm and therefore can have particular physical chemical properties and, above all, electronic and quantum-mechanical properties in connection with their sizes that are not present in case of particles having sizes higher than 100 nm.

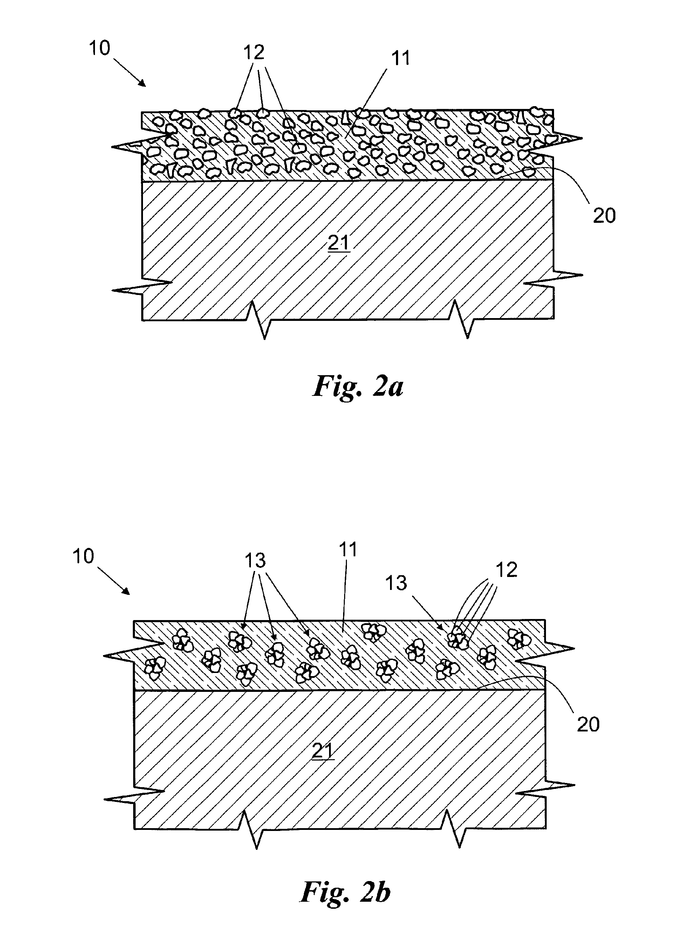

The nanoparticles 12 can then be, in turn, mutually aggregated in the form of nanoaggregates **13,** commonly referred to as nano-clusters or nano-powders, as diagrammatically shown in Fig. 2b.

For instance, it is advantageous to use nanoparticles 12 of zinc oxide for materials constituting spectacle lenses so as to increase the protective properties against UV rays to a great extent. It is possible to use nanoparticles 12 enabling colorations to be obtained that are not obtainable with traditional particles, or yet to use nanoparticles 12 allowing the resistance to scratch of the surface and the hardness thereof to be greatly increased.

In addition, the process 1 is obtained in a suitable apparatus **30** comprising a reactor **31** for film depositions through PVD techniques.

In fact, the Applicant has surprisingly found that the aggregating layer 11 laid down through a physical cold process, such as the PVD process, can be capable of incorporating and retaining the nanoparticles 12 inside it.

Suitably present at the inside of reactor 31 is a frame **32** that is preferably movable inside the reactor 32 itself; it is in particular a rotary frame and is adapted to support the elements 21 while process 1 is being carried out.

This reactor 31 is known by itself and manufacture for example by the same Applicant, Protec Surface Technologies S.r.l., under the trade name Pro Power.

Reactor 31 preferably consists of a single chamber and therefore puts into practice a process commonly named "batch process".

Alternatively, the reactor 31 can consist of a plurality of chambers, each of them adapted to accomplish a different sub-step, known by itself, of the deposition step 2.

A further alternative solution contemplates a reactor 31 made up of reactors commonly referred to as "roll-to-roll" reactors in which, summarily, elements 21 are in the form of a rolled-up ribbon that is unrolled and rolled up again while causing it to pass inside PVD deposition chambers.

Preferably the vacuum or a controlled atmosphere is created at the inside of reactor 31.

### Reactor 31 can then be connected to an additional tank 33.

The additional tank 33 is preferably external to reactor 31; however alternatively it can be provided at the inside of reactor 31. It is adapted to contain the nanoparticles 12 before the inclusion step 3.

The additional tank 33 is connected to reactor 31 through a duct **34,** consisting of flanges or the like, that can be suitably closed by an appropriate valve 35, disposed along the duct 34 and adapted either to enable or to fully or partly inhibit flowing of the nanoparticles 12 towards reactor 31.

The process 1 mainly comprises, as already pointed out, the simultaneous deposition 2 and inclusion 3 steps.

The deposition step 2 takes place in reactor 31 and is known by itself and consists of a deposition process of a film through high vacuum. By this term, mainly the PVD processes known by themselves are intended.

Substantially, during such a deposition step 2, the materials that have to constitute the film are made available, in the form of gases, vapours and/or particles for example, inside the volume of reactor 31 where preferably a vacuum or a controlled atmosphere is created and where the elements 21 are disposed on frame 32 and preferably moved by the frame 32 itself.

The particles or the like present within the chamber therefore come into contact with the surfaces to be coated 20 of elements 21 to which they adhere.

The aggregating layer 11 can therefore be of various nature, thickness, density, and can comprise overlapping layers.

The inclusion step 3 of nanoparticles 12 is carried out simultaneously with the deposition step 2.

In addition, it can be shorter than the deposition step 2 and therefore can begin at a subsequent time relative to beginning of the deposition step 2 and/or have an end preceding the end of the deposition step 2.

During the inclusion step 3 the nanoparticles 12 are diffused inside the reactor 31 and therefore come into contact with the surfaces to be coated 20 at least partly coated with the aggregating layer 11.

They are then retained and at least partially incorporated, i.e. partly or fully encapsulated by the aggregating layer 11 during formation of the latter. Consequently, the nanoparticles 12 too are fastened to the surfaces to be coated 20.

Moreover, the inclusion step 3 can be suitable preceded by a preparation step 4 of the nanoparticles 12.

The preparation step **4** can be, for example, obtained by evaporation, ablation, plasma formation or exfoliation of a solid, liquid or gaseous target **14** comprising said nanoparticles 12 or consisting of the same materials as those that will form said nanoparticles 12.

Evaporation of targets 14 can take place by heating or by techniques known as magnetron sputtering.

Other techniques for evaporation of targets 14 consist in bombarding the same either through ion or electron beams (IB-PVD or EB-PVD techniques) or through a high-power pulsed laser beam (Pulsed Laser Deposition).

The preparation step 4 can take place inside the additional tank 33 or directly within reactor 31.

In the first case the nanoparticles 12 are subsequently conveyed through duct 34 into reactor 31.

Conveying of the nanoparticles 12 can for instance take place either by fall or by pressure difference, or by means of a simultaneous flow of a carrier gas or liquid adapted to carry the particles and possibly chemically react during the deposition step 2.

The combined flow of nanoparticles 12 and carrier gas or liquid can be conveyed to reactor 31 also through ionic or plasma sources or different feeding systems.

In the second case the nanoparticles 12 or target 14 are directly disposed at the inside of reactor 31 or also on frames 32.

### The invention enables important advantages to be achieved.

In fact, process 1 allows a thin film 10 to be made which includes any type of particles or nanoparticles, on any surface to be coated 20.

Another purpose representing an advantage of process 1 consists in that it is possible to coat surfaces 20 with nanoparticles 12 having the desired particular physico-chemical surface properties. Specifically, high surface hardness, high tribologic properties, particular colorations, fluorescence, antiseptic character and others.

The invention is susceptible of variants all falling within the scope of the inventive idea. All of the details can be replaced by equivalent elements and the materials, shapes and sizes can be of any nature and magnitude.

## Claims

1. A deposition process (1) of film (10) on surfaces to be coated (20) comprising:
- a deposition step (2) of an aggregating layer (11) consisting in a high-vacuum deposition process, and an inclusion step (3) of nanoparticles (12) simultaneous with said deposition step (2), and **characterised in that** said deposition step (2) takes place through PVD techniques and **in that** said aggregating layer (11) is suitable to retain and at least partly encapsulate said nanoparticles (12) on said surface to be coated (20).

2. A deposition process (1) according to the preceding claim, wherein said nanoparticles (12) have at least two dimensions of less than 100 nm.

3. A deposition process (1) according to one or more of the preceding claims, wherein said deposition step (2) is performed inside a reactor (31) and wherein during said inclusion step (3) said nanoparticles (12) are diffused inside said reactor (31).

4. A deposition process (1) according to one or more of the preceding claims, wherein said inclusion step (3) is preceded by a preparation step (4) of said nanoparticles.

5. A deposition process (1) according to claims 3 and 4, wherein said preparation step (4) is performed inside an additional tank (33) and is followed by a step of conveying said nanoparticles (12) to said reactor (31).

6. A deposition process (1) according to claims 3 and 4, wherein said preparation step (4) is performed directly inside said reactor (31).

7. An apparatus (30) for producing said deposition process (1) according to one or more of claims 1-6, comprising: a reactor (31) suitable to allow performance of said deposition step (2), **characterised in that** it comprises an additional tank (33) suitable to allow performance of said preparation step (4).

8. A film (10) produced by means of said deposition process (1) according to one or more of claims 1-6.
